(19) Europäisches Patentamt
European Patent Office
Office européen des brevets

(11) **EP 1 065 512 B1**

(12) **EUROPÄISCHE PATENTSCHRIFT**

(45) Veröffentlichungstag und Bekanntmachung des Hinweises auf die Patenterteilung:
**03.01.2007 Patentblatt 2007/01**

(51) Int Cl.:
***G01R 33/421*** *(2006.01)*

(21) Anmeldenummer: **00113537.5**

(22) Anmeldetag: **27.06.2000**

(54) **Aktiv abgeschirmte supraleitende Magnetanordnung mit Feldstörungskompensation**

Actively screened superconducting magnet arrangement with compensation of field disturbances

Arrangement d'aimants supraconducteurs activement blindés avec compensation de perturbations du champ

(84) Benannte Vertragsstaaten:
**CH DE FR GB LI**

(30) Priorität: **02.07.1999 DE 19930412**

(43) Veröffentlichungstag der Anmeldung:
**03.01.2001 Patentblatt 2001/01**

(73) Patentinhaber: **Bruker BioSpin AG**
**8117 Fällanden (CH)**

(72) Erfinder:
• **Schauwecker, Robert, Dipl.-Phys.**
**8032 Zürich (CH)**

• **Bovier, Pierre-Alain, Dr.sc.nat, Dipl.-Phys.**
**8051 Zürich (CH)**
• **Eckert, Daniel, Dr.sc.nat, Dipl.-Phys**
**8600 Dübendorf (CH)**
• **Westphal, Michael, Dr. Dipl.-Ing.**
**76877 Offenbach (DE)**

(74) Vertreter: **Kohler Schmid Möbus**
**Patentanwälte**
**Ruppmannstrasse 27**
**70565 Stuttgart (DE)**

(56) Entgegenhaltungen:
**EP-A- 0 488 464**     **US-A- 5 426 366**

**Beschreibung**

Die Erfindung betrifft eine aktiv abgeschirmte, supraleitende Magnetanordnung zur Erzeugung eines Magnetfeldes in Richtung einer z-Achse in einem um z = 0 angeordneten Arbeitsvolumen mit einem radial inneren und einem dazu koaxialen radial äußeren Spulensystem, wobei die beiden Spulensysteme näherungsweise den gleichen Strom tragen und näherungsweise entgegengesetzt gleich große Dipolmomente aufweisen, wobei zumindest Teile des radial äußeren Spulensystems mit dem radial inneren Spulensystem elektrisch in Serie geschaltet sind, und wobei ein erster supraleitender Schalter vorgesehen ist, über den im Betriebszustand ein supraleitender Kurzschluß eines ersten Strompfades der Magnetanordnung bewirkt werden kann.

Eine derartige aktiv abgeschirmte, supraleitende Magnetanordnung ist bekannt aus der US-A 5,426,366.

Das Einsatzgebiet von supraleitenden Magneten umfaßt verschiedene Anwendungsfelder, insbesondere die Magnetresonanzverfahren, in welchen in der Regel die zeitliche Stabilität des Magnetfeldes wichtig ist. Zu den anspruchsvollsten Anwendungen gehört die hochauflösende Kernresonanz-Spektroskopie (NMR-Spektroskopie). Zeitliche Feldfluktuationen können sowohl vom supraleitenden Magneten selbst als auch von seiner Umgebung verursacht werden. Während mit der aktuellen Magnet- und Leitertechnologie zeitlich sehr stabile Felder erzeugt werden können, besteht auf dem Gebiet der Unterdrückung externer magnetischer Störungen noch Handlungsbedarf. Im folgenden werden Wege aufgezeigt, wie diesen Störungen entgegengewirkt werden kann. Der Schwerpunkt liegt auf dem Gebiet der Störkompensation bei supraleitenden Solenoidmagneten mit aktiver Streufeldabschirmung.

Die US-A 4,974,113 beschreibt u. a. einen kompensierenden supraleitenden Solenoidmagneten, wobei jedoch keine aktive Abschirmung des Magnetsystems erwähnt ist. Die Idee dabei besteht darin, daß mindestens zwei voneinander unabhängige supraleitende Strompfade mittels zweier koaxial angeordneter supraleitender Solenoidspulen realisiert und so berechnet sind, daß auftretende externe Magnetfeldstörungen im Inneren der Anordnung und unter Berücksichtigung der Erhaltung des magnetischen Gesamtflusses für jeden geschlossenen supraleitenden Strompfad im Langzeitverhalten auf einen Restwert von höchstens 20% der ursprünglichen Störung unterdrückt werden.

Eine ähnliche Vorrichtung zur Kompensation von elektromagnetischen Störungen im Arbeitsvolumen einer supraleitenden Magnetanordnung mittels eines zusätzlichen supraleitend kurzgeschlossenen Spulensystems ist bekannt aus EP-A 0'488'464. Diese Anordnung umfasst Kompensationsspulen mit unterschiedlichen Durchmessern. Es wird auch eine aktiv abgeschirmte Magnetspulenanordnung mit einem zusätzlichen Kompensationsspulensystem beschrieben. Im Falle eines Quenchs der Magnetspulenanordnung können in den Kompensationsspulen hohe Ströme induziert werden. Wenn dies verhindert werden soll, ist es wünschenswert, die Kompensationsspulen von der Magnetspulenanordnung induktiv zu entkoppeln.

Eine Anwendung der Idee aus US-A 4,974,113 auf ein aktiv abgeschirmtes Magnetsystem ist in der US-A 5,329,266 beschrieben. Dort ist eine Vielzahl von abschirmenden, strukturierten Kompensationsspulen vorgesehen, welche supraleitend in Serie geschaltet sind und jeweils für sich eine im Verhältnis zu den Hauptspulen geringe Stromtragfähigkeit in der Größenordnung von maximal einem Ampere aufweisen, damit im Falle eines Zusammenbruchs der Supraleitung (=Quench) das von der Magnetanordnung nach außen dringende Streufeld möglichst gering bleibt.

Einen alternativen Weg zeigt die US-A 4,926,289 auf, in der ein aktiv abgeschirmtes, supraleitendes Magnetsystem mit einem radial inneren und einem radial äußeren, supraleitend kurzgeschlossenen Spulensystem beschrieben ist, wobei zwischen dem inneren und dem äußeren Spulensystem ein supraleitender Kurzschluß mit begrenzter Stromtragfähigkeit vorgesehen ist, der als Differenzstrombegrenzer wirken soll. Eine Kompensation von externen Störungen wird dadurch ermöglicht, daß sich durch den supraleitenden Strombegrenzer zwischen den beiden Spulensystemen eine Verschiebung der Stromverteilung zwischen dem radial inneren und dem radial äußeren supraleitenden Strompfad ergeben kann. Im Quenchfall soll die geringe Stromtragfähigkeit des Differenzstrombegrenzers sicherstellen, daß das von der Magnetanordnung erzeugte externe Streufeld klein bleibt.

Das Problem einer Kompensation von externen Magnetfeldstörungen bei aktiv abgeschirmten Magnetsystemen wird also durch den oben geschilderten Stand der Technik entweder mittels einer oder mehrerer zusätzlich zu den Feldspulen vorgesehenen Kompensationsspulen oder durch eine Unterteilung des Spulensystems in supraleitend kurzgeschlossene Abschnitte dahingehend gelöst, daß homogene äußere Magnetfeldstörungen im Arbeitsbereich des jeweiligen Magnetsystems im Langzeitverhalten auf weniger als 20% reduziert werden.

Eine weitere Verbesserung gegenüber dem Magnetsystem nach der US-A 4,926,289 ist in der eingangs zitierten US-A 5,426,366 beschrieben. Danach soll der Differenzstrombegrenzer als Teilkurzschluß über einem Abschnitt des radial inneren Spulensystems ausgeführt werden. Dadurch, daß sich der Differenzstrombegrenzer nicht wie bei der US-A 4,926,289 mit seinen Anschlußpunkten zwischen den beiden Enden des radial inneren Spulensystems erstreckt, sondern die Anschlußpunkte mit Abstand von den Spulenenden über einem Teilabschnitt des radial inneren Spulensystems gewählt werden können, ergibt sich ein zusätzlicher Freiheitsgrad für die Optimierung der Störkompensation des Systems. Weitere Freiheitsgrade können durch Aufteilung des Differenzstrombegrenzers in mehrere Teilabschnitte über dem radial inneren Spulensystem gewonnen werden.

Nachteilig bei dem Magnetsystem nach der US-A 5,426,366 ist jedoch, daß der Teilabschnitt des radial inneren Spulensystems mit dem Rest des Magnetsystems induktiv koppelt. Diese Kopplung kann auf unerwünschte Nebeneffekte führen, wie Verstärkung der Magnetdrift oder unkontrolliertes Aufladen des Abschnitts (zeitliche Verzerrung der Homogenität, eventueller Streufeldanstieg, Aufladen bis zum Quench). Um diesen Problemen vorzubeugen, wird ein Strombegrenzer eingeführt. Der Strombegrenzer hat aber den Nachteil, daß er einen allfälligen Strom abbauen kann. Der Abbau dieses Stromes ist für den Magneten eine Störung, die er nicht kompensieren kann.

Aufgabe der vorliegenden Erfindung ist es demgegenüber, eine Magnetanordnung der eingangs beschriebenen Art mit möglichst einfachen Maßnahmen so zu modifizieren, daß die oben genannten Nachteile vermieden werden.

Erfindungsgemäß wird diese Aufgabe dadurch gelöst, daß durch einen weiteren supraleitenden Schalter ein symmetrisch zur Ebene z = 0 angeordneter Abschnitt des radial äußeren Spulensystems im Betriebszustand supraleitend kurzschließbar ist, und daß der durch den supraleitend kurzgeschlossenen Abschnitt des radial äußeren Spulensystems gebildete weitere supraleitende Strompfad von den in Serie geschalteten übrigen Teilen der Magnetanordnung, abgesehen von einer eventuellen Restkopplung aufgrund von Produktionsungenauigkeiten, induktiv entkoppelt ist, wobei bei Auftreten einer homogenen externen Magnetfeldstörung der supraleitend Kurzgeschlossene Abschnitt so mit der Magnetfeldstörung koppelt, daß die z-Komponente der Magnetfeldstörung im Arbeitsvolumen der Magnetanordnung durch in dem Abschnitt induzierte Ströme weitgehend kompensiert wird.

Falls in einem supraleitenden Magnetsystem mehrere induktiv koppelnde supraleitende Strompfade vorhanden sind, können ungewünschte Nebeneffekte auftreten, wie Verstärkung der Magnetdrift, unkontrolliertes Aufladen eines Strompfades und daraus folgende zeitliche Verzerrung der Homogenität, evtl. Streufeldanstieg, Aufladen bis zum Quench, Dissipation von Energie in Schaltern beim Laden des Magnetsystems, große Überströme in einem Strompfad im Falle des Quenches eines anderen Strompfades etc.. Diese Probleme werden in der Erfindung durch die gegenseitige induktive Entkopplung der supraleitenden Strompfade gelöst. Ein vom Rest des Magneten induktiv entkoppelter Abschnitt befindet sich typischerweise in den innersten Lagen des äußeren Spulensystems. Damit entfallen die unerwünschten Nebeneffekte der Kopplung, und der im Stand der Technik vorgesehene Strombegrenzer verliert seine Notwendigkeit.

In der Realität muß immer mit einer Restkopplung aufgrund von Produktionsungenauigkeiten gerechnet werden. Daher kann im Falle des Quenches eines der supraleitenden Strompfade gleichwohl ein Strom in einem anderen Strompfad induziert werden. Um hohe elektromagnetische Kräfte im Quenchfall zu vermeiden, muß der Abschnitt die gleiche Symmetrieebene und Symmetrieachse haben wie der gesamte Magnet.

Der supraleitend kurzgeschlossene Abschnitt des radial äußeren Spulensystems kann auch in mehrere Unterabschnitte aufgeteilt sein. Mit einer feineren Unterteilung der Strompfade in viele Abschnitte wird das Verhalten der Störkompensation gegenüber bekannten Magnetsystemen noch weiter verbessert, weil noch mehr Freiheitsgrade zur Optimierung des Störverhaltens erhalten werden.

Die obengenannten Vorteile der Erfindung zahlen sich besonders in empfindlichen Systemen aus. Deshalb ist bei einer bevorzugten Ausführungsform die erfindungsgemäße Magnetanordnung Teil einer Apparatur zur hochauflösenden Magnetresonanz-Spektroskopie, beispielsweise auf dem Gebiet der NMR, ICR oder MRI.

NMR-Apparaturen weisen normalerweise eine Einrichtung zur Stabilisierung des im Arbeitsvolumen erzeugten Magnetfeldes auf. Diese verwendet eine Lock-Spule zur Korrektur sowie ein NMR-Signal zur Detektion der Feldstörung und wird als NMR-Lock bezeichnet.

Es sollte allerdings gewährleistet sein, daß vorhandene aktive Vorrichtungen zur Kompensation von Magnetfeldfluktuationen, wie z.B. dieser NMR-Lock, nicht mit dem erfindungsgemäßen Entstörkonzept des Magneten wechselwirken. Deshalb ist bei einer Weiterbildung der obigen Ausführungsform vorgesehen, daß der supraleitende Strompfad des kurzgeschlossenen Abschnitts weitgehend von der Lock-Spule entkoppelt sind. Der Vorteil der induktiven Entkopplung der supraleitenden Strompfade von der Lock-Spule besteht darin, daß die Wirkung des NMR-Locks durch den Magneten nicht behindert wird, und daß die Wechselwirkung des Feldlocks mit dem gesamten Magnetsystem durch das Anbringen des zusätzlichen Schalters nicht beeinflußt wird.

Falls das Magnetfeld mit sweep-Spulen moduliert werden soll, was an sich aus dem Stand der Technik bekannt ist, darf diese Modulation vom Magneten nicht wie eine externe Störung kompensiert werden. Bei einer anderen Weiterbildung der Erfindung ist daher der supraleitende Strompfad des kurzgeschlossenen Abschnitts weitgehend von den Sweep-Spulen entkoppelt. Der Vorteil der induktiven Entkopplung von den sweep-Spulen besteht darin, daß der Magnet für das sweep-Feld transparent ist, und daß die Wechselwirkung der Sweep-Spulen mit dem gesamten Magnetsystem durch das Anbringen des zusätzlichen Schalters nicht beeinflußt wird.

Besonders bevorzugt ist eine Ausführungsform der Erfindung, bei der der supraleitend kurzgeschlossene Abschnitt aus den n radial innersten Lagen des äußeren Spulensystems besteht, wobei vorzugsweise n $\leq$ 4. Damit ist die Entkopplung des supraleitend kurzgeschlossenen Abschnitts vom Rest der Magnetanordnung in den radial innersten Lagen der Streufeldabschirmspulen am einfachsten zu verwirklichen.

Durch die Entkopplung des supraleitend kurzgeschlossenen Abschnitts vom Rest der Magnetanordnung wird erreicht, daß bei einer externen Feldfluktuation beide Anteile der Magnetanordnung autonom voneinander reagieren, d.h. die aufgebauten Kompensationsfelder beider Anteile überlagern sich additiv. Falls der supraleitend kurzgeschlossene Abschnitt nur einen kleinen Anteil der Windungen der Streufeldabschirmung umfaßt, verhält sich der Rest der Magnetanordnung gegenüber einer externen Feldfluktuation näherungsweise wie ein Magnet mit aktiver Streufeldabschirmung, also transparent. Dagegen verhält sich beispielsweise eine dünne stromtragende zylindrische Fläche annähernd wie ein idealer Schild gegenüber magnetischen Störungen. Eine Magnetanordnung, bestehend aus einem nichtkompensierenden Anteil und einem von letzterem induktiv entkoppelten ideal kompensierenden Anteil, verhält sich insgesamt wie ein ideal störkompensiertes System.

Weitere Freiheitsgrade zur Optimierung einer Magnetanordnung hinsichtlich externer Feldstörungen ergeben sich, wenn eine mit den beiden koaxialen Spulensystemen galvanisch nicht verbundene Kompensationsspule koaxial zu den beiden Spulensystemen angeordnet ist und einen zusätzlichen im Betriebszustand supraleitend kurzgeschlossenen Strompfad bildet.

Da der supraleitend kurzgeschlossene Abschnitt Teil der felderzeugenden Magnetanordnung ist, sollte im Betriebszustand der volle Betriebsstrom auch in diesem Abschnitt fließen. Dies wird bevorzugt dadurch erreicht, daß alle Spulenanteile der Magnetanordnung in Serie geschaltet werden, insbesondere der supraleitend kurzgeschlossene Abschnitt mit dem Rest der Magnetanordnung. Bei offenen Schaltern fließt dann fährend der Ladephase der Magnetanordnung in der ganzen Anordnung aufgrund der Kontinuitätsgleichung derselbe Strom, d.h. die gesamte Anordnung erreicht simultan den Betriebsstrom.

Im folgenden sollen zwei konkrete Realisierungsvarianten der Verdrahtung einer erfindungsgemäßen Magnetanordnung angegeben werden:

Falls verschiedene supraleitende Strompfade z.B. auf unterschiedlichen Magnetsektionen gewickelt sind, ist es einfacher, sie nur resistiv zu verbinden. Durch die resistive Verbindung wird ein gemeinsames Laden ermöglicht. Eine Ausführungsform, bei der mindestens ein Teil der im Betriebszustand supraleitend kurzgeschlossenen Strompfade resistiv miteinander verbunden sind, ist daher produktionstechnisch vorteilhaft.

Eine zweite einfache Ausführungsform, bei der die im Betriebszustand supraleitend kurzgeschlossenen Strompfade miteinander supraleitend in Serie geschaltet sind, ist technisch ebenfalls leicht zu realisieren.

Eine bevorzugte Weiterbildung der letztgenannten Ausführungsform sieht vor, daß der supraleitend kurzgeschlossene Abschnitt des radial äußeren Spulensystems, einen mit diesem Abschnitt parallel geschalteten und mit dem weiteren supraleitenden Schalter in Serie geschalteten Strombegrenzer aufweist. Der Strombegrenzer stellt eine Sicherung gegenüber unerwünschten Langzeiteffekten dar, indem sich nur limitierte Differenzströme zwischen dem supraleitend kurzgeschlossenen Abschnitt und dem Rest der Magnetanordnung aufbauen können.

Während des Ladens von Teilen der Magnetanordnung müssen unter Umständen mehrere der supraleitend kurzgeschlossenen Pfade unter Strom gesetzt werden, d.h. ihre Schalter müssen gleichzeitig geheizt werden. In anderen supraleitend kurzgeschlossenen Strompfaden, z.B. Kompensationsspulen, Shims etc., muß dagegen ein allfällig induzierter Strom ständig über dem Schalter abgebaut werden, weshalb auch die Schalter dieser Strompfade geheizt werden müssen. Bevorzugt ist daher eine Weiterbildung der erfindungsgemäßen Magnetanordnung, bei der die Heizeinrichtungen mindestens zweier supraleitender Schalter elektrisch in Serie geschaltet sind. Der Vorteil dieser Anordnung besteht darin, daß durch die Serienschaltung von Schalterheizern die Anzahl der Heizerstromzuleitungen im Stromstab reduziert werden kann, und daß die Handhabung der Magnetanordnung einfacher und sicherer wird.

Während des Ladens einer Shimspule kann zwischen dem supraleitend kurzgeschlossenen Abschnitt und dem Rest der Magnetanordnung ein Differenzstrom induziert werden. Falls der supraleitend kurzgeschossene Abschnitt und der Rest der Magnetanordnung supraleitend in Serie geschaltet sind, fließt der Differenzstrom über den Schalter des supraleitend kurzgeschlossenen Abschnitts und kann durch Öffnen dieses Schalters abgebaut werden. Vorteilhaft ist daher eine Anordnung, bei der der Schalterheizer des Abschnitts mit dem Shimschalterheizer in Serie geschaltet ist. Dadurch wird beim Laden des Shims, wenn der zugehörige supraleitende Schalter geheizt wird, der Schalter des Abschnitts automatisch ebenfalls geheizt.

Bei einer bevorzugten Weiterbildung ist die Heizeinrichtung mindestens eines supraleitenden Schalters separat heizbar. Dadurch können Vorteile der Serienschaltung der Heizer, wie z.B. die einfache Handhabung, genutzt werden, aber trotzdem können die supraleitenden Strompfade mit zusätzlich separat heizbarem Schalter individuell geladen werden. Außerdem kann man induzierte Ströme zu jeder Zeit durch das Heizen des Schalters eliminieren.

Eine besonders bevorzugte Ausführungsform der erfindungsgemäßen Magnetanordnung zeichnet sich dadurch aus, daß der supraleitend kurzgeschlossene Abschnitt geometrisch so gestaltet und dimensioniert ist, daß die Homogenität des von der Magnetanordnung erzeugten Magnetfelds im Arbeitsvolumen bei Auftreten einer externen Magnetfeldstörung im wesentlichen erhalten bleibt. Der Vorteil besteht darin, daß das Feld im Arbeitsvolumen während einer externen Feldfluktuation sowohl zeitlich als auch örtlich nicht variiert.

Bei einer weiteren vorteilhaften Ausführungsform schließlich wird zur induktiven Entkopplung des durch den supraleitend kurzgeschlossenen Abschnitt gebildeten Strompfades von den in Serie geschalteten übrigen Teilen der Magnetanordnung eine unterschiedliche Polarität des radial inneren und des radial äußeren Spulensystems ausgenutzt. Indem die unterschieliche Polarität des radial inneren und des radial äußeren Spulensystems zur Entkopplung des supraleitend kurzgeschlossenen Abschnitts vom Rest der Magnetanordnung genutzt wird, kann im supraleitend kurzgeschlossenen Abschnitt auf Spulen verschiedener Polaritäten verzichtet werden.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fig. 1. ein Schaltschema einer ersten Ausführungsform der erfindungsgemäßen Magnetanordnung mit supraleitenden Verbindungen der supraleitend geschlossenen Strompfade;

Fig. 2. eine weitere Ausführungsform mit resistiven Verbindungen der supraleitend geschlossenen Strompfade; und

Fig. 3. eine dritte Ausführungsform mit integriertem Strombegrenzer im supraleitend kurzgeschlossenen Abschnitt des radial äußeren Spulensystems.

Wir betrachten eine supraleitend kurzgeschlossene Spule und ihr Verhalten beim Auftreten externer Magnetfeldfluktuationen. Nach der Lenz'schen Regel gilt :

$$L\frac{dI}{dt} = -\frac{d\Phi}{dt}$$

mit den Größen :

L : Eigeninduktivität der Spule

I : Strom durch die Spule

$\Phi = \int B(r,z,\varphi)dS$ : Magnetischer Fluß der externen Fluktuation durch die Spule

$\frac{d\Phi}{dt}$ : zeitliche Änderung des magnetischen Flusses

Die zeitliche Variation des Stromes in der Spule ist also proportional zur zeitlichen Variation des Flusses der externen Feldfluktuation, d. h.

$$L\Delta I = -\Delta\Phi$$

Als Maß für die Störbarkeit eines Magneten **definieren wir den Betafaktor** β als das Verhältnis zwischen der resultierenden $B_z$-Feld Änderung im magnetischen Zentrum (= Überlagerung der $B_z$-Komponente der Störung und des vom Magneten aufgebauten Kompensationsfeldes) zur $B_z$-Komponente der Störung. Der Betafaktor beschreibt die Fähigkeit eines Magneten, äußere Störungen im magnetischen Zentrum zu kompensieren. Ist beispielsweise β=0, ist die Störung im magnetischen Zentrum unsichtbar. β>0 bedeutet, daß die Induktionsströme die Störung unterkompensieren. β<0 bedeutet hingegen, daß die Induktionsströme so groß sind, daß die Störung im Magnetzentrum überkompensiert wird.

Wenn $B_z$ die z-Komponente des Störfeldes im magnetischen Zentrum bezeichnet (ohne Kompensationsströme der Spule) und b das Magnetfeld der Spule pro Ampere Strom im magnetischen Zentrum, ist der Betafaktor :

$$\beta = 1 + \frac{b \cdot \Delta I}{B_z} = 1 - \frac{b \cdot \Delta \Phi}{LB_z}$$

Wir definieren jetzt die "effektive Fläche" A der Spule bezüglich der Störung als

$$A = \frac{\Delta\Phi}{B_z}$$

Bei einer homogenen Feldfluktuation ist dies einfach die von der Spule umschlossene Fläche.

Der Betafaktor läßt sich jetzt einfacher schreiben als

$$\beta = 1 - \frac{b}{L} \cdot A .$$

Besteht ein Magnet aus einer einzigen supraleitenden Spule, ist sein Kompensationsvermögen von externen Feldfluktuationen meistens nicht ideal. Dies ist insbesondere der Fall für aktiv abgeschirmte Magnete, da dort die effektive Fläche $A$ klein ist, was zu einer Unterkompensation von Störungen führt ($\beta > 0$). Der Magnet ist für Störungen praktisch transparent.

Nach dem Stand der Technik kann man die Situation verbessern, indem man entweder einen Abschnitt des Magneten separat über einen supraleitenden Schalter kurzschließt (US 5,426,366) oder eine zusätzliche supraleitende Spule einbaut (US 4,974,113). Auf jeden Fall erhöht man die Anzahl der supraleitenden Stromkreise und schenkt sich somit mehr Freiheitsgrade zur Optimierung des Störverhaltens.

Bei mehreren supraleitenden Strompfaden ist es wünschenswert, diese induktiv voneinander zu entkoppeln. Vor allem bei aktiv abgeschirmten Magneten kann es sonst zu einer Erhöhung des Streufeldes kommen, wenn der Magnet driftet oder wenn sich der Hauptschalter öffnet und sich der Magnet langsam entlädt. Falls die Entkopplung nicht möglich ist, muß in den zusätzlichen supraleitenden Strompfaden entweder ein kleiner Widerstand oder ein Strombegrenzer eingebaut werden, was aber nicht Gegenstand der vorliegenden Erfindung ist.

Bei einem aktiv abgeschirmten Magneten muß es einen Ort geben, wo eine Spule gleich stark mit dem negativ polarisierten wie mit dem positiv polarisierten Teil des Magneten koppelt. Die resultierende Kopplung mit dem gesamten Magneten ist null. Es ist oft so, daß die ersten wenigen Lagen der Abschirmung diese Bedingung erfüllen. Schließt man diese Lagen über einen supraleitenden Schalter kurz, hat man meistens Entkopplung und zugleich eine gute Kompensation von externen Feldfluktuationen.

Sind die n supraleitenden Strompfade voneinander entkoppelt, wird der Betafaktor einfach

$$\beta = 1 - \sum_{i=1}^{n} \frac{b_i}{L_i} \cdot A_i$$

d.h. daß wir eine additive Überlagerung der Kompensationsfelder aller Strompfade haben.

Meistens sind realistische externe Feldfluktuationen relativ homogen. Wenn die Magnetfelder der supraleitenden Strompfade aber nicht je für sich homogen sind, kann es vorkommen, daß eine externe Feldfluktuation wegen der induzierten Ströme zu einer Verzerrung der Homogenität im Arbeitsvolumen führt. Man muß also darauf achten, daß das Magnetfeld jedes supraleitenden Strompfades für sich homogen ist.

Bei den Magnetsystemen, die uns interessieren, sind die Magnetspulen alle koaxial (die gemeinsame Achse wollen wir $z$ nennen) und um die Ebene $z=0$ symmetrisch angeordnet. Es ist wichtig, daß diese Symmetrien bei kurzgeschlossenen Abschnitten oder zusätzlichen Spulen ebenfalls vorhanden sind. Ansonsten könnte es vorkommen, daß die Stromverteilung im Quenchfall unsymmetrisch wird. Unsymmetrische Stromverteilungen erzeugen unerwünschte unsymmetrische Lorentzkräfte, die bei großen Magneten zu Beschädigungen führen können.

Es ist zu empfehlen, daß die Heizer der Schalter der zusätzlichen supraleitenden Strompfade mit dem Hauptschalterheizer des Magneten in Serie geschaltet werden. So ist gewährleistet, daß beim Laden und Entladen des Magneten mit offenem Hauptschalter die anderen Schalter auch offen sind. Allfällige Restkopplungen zwischen zusätzlichen supraleitenden Strompfaden und Magnet können auf diese Weise nicht zu einem Aufladen dieser Pfade führen.

Für Testzwecke ist es sinnvoll, wenn man die Heizer der Schalter der zusätzlichen supraleitenden Pfade separat betätigen kann. So kann man beispielsweise die Kopplungen der verschiedenen Pfade experimentell bestimmen oder in die verschiedene Pfade verschiedene Ströme einfahren.

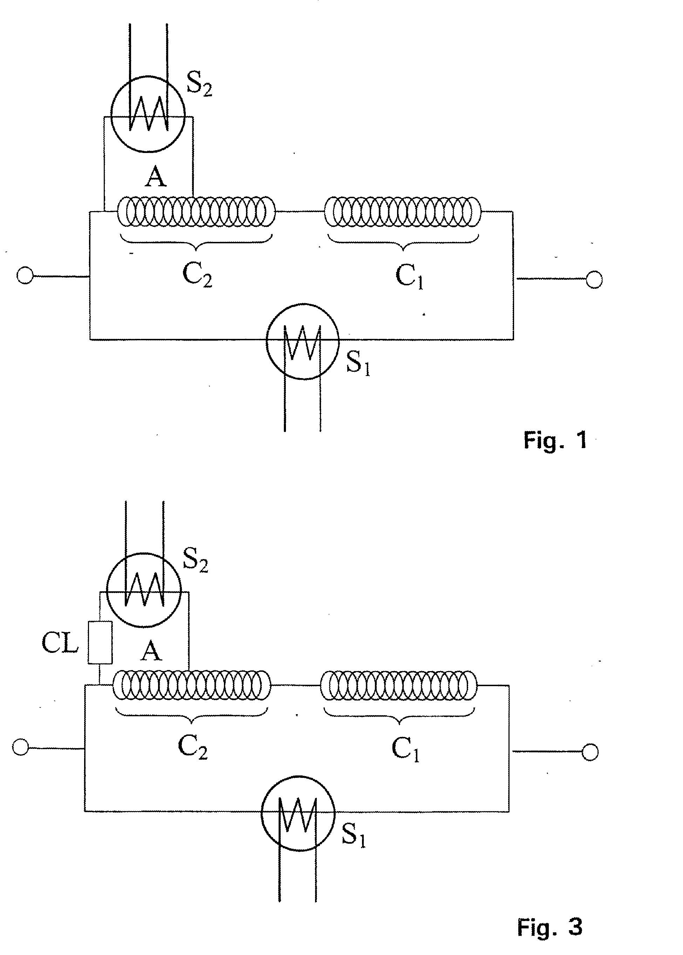

Die erfindungsgemäße supraleitende Magnetanordnung kann durch unterschiedliche Schaltungen realisiert werden. Drei konkrete Ausführungsbeispiele sind in den Figuren 1 bis 3 dargestellt, wobei prinzipiell funktionsgleiche Bauteile mit denselben Bezugsziffern gekennzeichnet sind.

In den Ausführungsbeispielen sind jeweils ein radial inneres Spulensystem $C_1$, ein radial äußeres Spulensystem $C_2$ bzw. $C_2'$ mit supraleitend kurzgeschlossenem Abschnitt A bzw. A' sowie zwei supraleitende Schalter $S_1$ und $S_2$ vorgesehen. Der Hauptschalter der Magnetanordnung, über den zumindest Teile von beiden koaxialen Spulensystemen $C_1$ und $C_2$ bzw. $C_2'$ supraleitend kurzgeschlossen werden können, ist der Schalter $S_1$. Der Schalter $S_2$ hingegen schließt jeweils nur den supraleitend kurzgeschlossenen Abschnitt A bzw. A' kurz.

Bei den Ausführungsbeispielen nach den Figuren 1 und 3 ist der supraleitend kurzgeschlossene Abschnitt A jeweils direkt supraleitend mit den übrigen Teilen des radial äußeren Spulensystems $C_2$ verbunden.

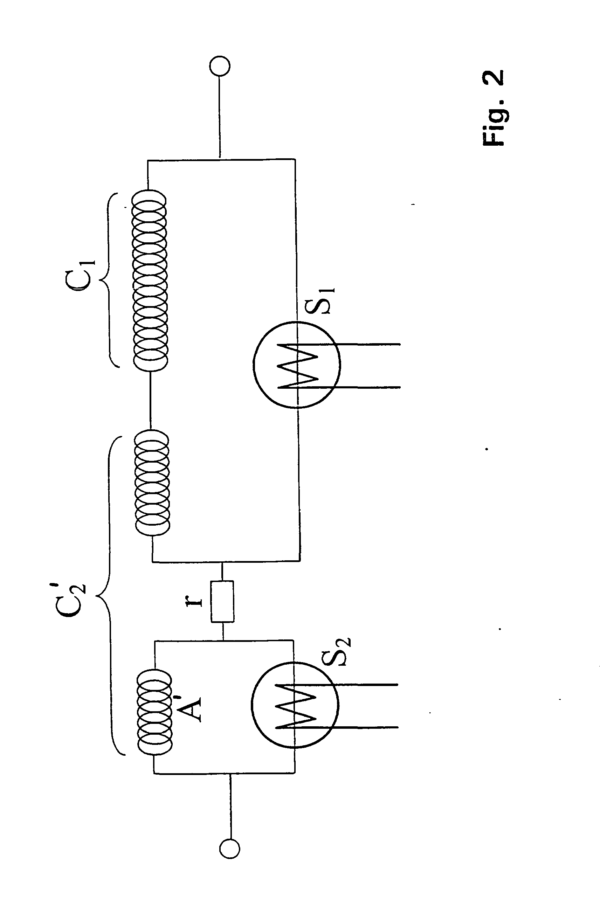

Alternativ kann, wie in Fig. 2 dargestellt, der supraleitend kurzgeschlossene Abschnitt A' mit den übrigen Teilen des radial äußeren Spulensystems $C_2'$ aber auch resistiv durch ein normalleitendes Verbindungsstück r in Serie geschaltet sein.

Es sei darauf hingewiesen, daß das normalleitende Verbindungsstück r in Fig. 2 lediglich zur deutlichen Unterscheidung vom Ausführungsbeispiel nach Fig. 1 als Ersatzwiderstand dargestellt ist. In der Praxis wird man das Verbindungsstück r in der Regel nicht durch einen Widerstand im Sinne eines elektrischen Bauteils, sondern durch einen einfachen, normalleitenden Leitungsabschnitt, beispielsweise aus Kupferdraht realisieren.

In Fig.3 schließlich ist ein Ausführungsbeispiel ähnlich dem nach Fig. 1 gezeigt, bei dem aber ein Strombegrenzer CL in den Strompfad des supraleitend kurzgeschlossenen Abschnitts A' integriert ist.

**Patentansprüche**

1. Aktiv abgeschirmte, supraleitende Magnetanordnung zur Erzeugung eines Magnetfeldes in Richtung einer z-Achse in einem um z = 0 angeordneten Arbeitsvolumen mit einem radial inneren und einem dazu koaxialen radial äußeren Spulensystem ($C_1$, $C_2$ bzw. $C_2$'), wobei die beiden Spulensysteme näherungsweise den gleichen Strom tragen und näherungsweise entgegengesetzt gleich große Dipolmomente aufweisen, wobei zumindest Teile des radial äußeren Spulensystems ($C_2$ bzw. $C_2$') mit dem radial inneren Spulensystem ($C_1$) elektrisch in Serie geschaltet sind, und wobei ein erster supraleitender Schalter ($S_1$) vorgesehen ist, über den im Betriebszustand ein supraleitender Kurzschluß eines ersten Strompfades der Magnetanordnung bewirkt werden kann,
   **dadurch gekennzeichnet,**
   **daß** durch einen weiteren supraleitenden Schalter ($S_2$) ein symmetrisch zur Ebene z = 0 angeordneter Abschnitt (A bzw. A') des radial äußeren Spulensystems ($C_2$ bzw. $C_2$'), im Betriebszustand supraleitend kurzschließbar ist und daß der durch den supraleitend kurzgeschlossenen Abschnitt (A; A') des radial äußeren Spulensystems ($C_2$; $C_2$') gebildete weitere supraleitende Strompfad von den in Serie geschalteten übrigen Teilen der Magnetanordnung, abgesehen von einer eventuellen Restkopplung aufgrund von Produktionsungenauigkeiten, induktiv entkoppelt ist, wobei bei Auftreten einer homogenen externen Magnetfeldstörung der supraleitend kurzgeschlossene Abschnitt (A bzw. A') so mit der Magnetfeldstörung koppelt, daß die z-Komponente der Magnetfeldstörung im Arbeitsvolumen der Magnetanordnung durch in dem Abschnitt induzierte Ströme weitgehend kompensiert wird.

2. Magnetanordnung nach Anspruch 1, **dadurch gekennzeichnet, daß** die Magnetanordnung Teil einer Apparatur zur hochauflösenden Magnetresonanz-Spektroskopie ist.

3. Magnetanordnung nach Anspruch 2, **dadurch gekennzeichnet, daß** die Magnetresonanz-Apparatur eine Einrichtung zum Feldlock des im Arbeitsvolumen erzeugten Magnetfelds aufweist, welche vom supraleitend kurzgeschlossenen Abschnitt (A; A') weitgehend entkoppelt ist.

4. Magnetanordnung nach Anspruch 2 oder 3, **dadurch gekennzeichnet, daß** die Magnetresonanz-Apparatur Sweep-Spulen aufweist, welche vom supraleitend kurzgeschlossenen Abschnitt (A; A') weitgehend entkoppelt sind.

5. Magnetanordnung nach einem der vorhergehenden Ansprüche, **dadurch gekennzeichnet, daß** der supraleitend kurzgeschlossene Abschnitt (A; A') aus den n radial innersten Lagen des äußeren Spulensystems ($C_2$; $C_2$') besteht, wobei vorzugsweise $n \leq 4$.

6. Magnetanordnung nach einem der Ansprüche 1 bis 5, **dadurch gekennzeichnet, daß** der im Betriebszustand supraleitend kurzgeschlossene Abschnitt mit den übrigen Teilen des radial äußeren Spulensystems resistiv in Serie geschaltet ist.

7. Magnetanordnung nach einem der Ansprüche 1 bis 5, **dadurch gekennzeichnet, daß** der im Betriebszustand supraleitend kurzgeschlossene Abschnitt mit den übrigen Teilen des radial äußeren Spulensystems supraleitend in Serie geschaltet ist.

8. Magnetanordnung nach einem der vorhergehenden Ansprüche, **dadurch gekennzeichnet, daß** eine mit den beiden koaxialen Spulensystemen ($C_1$, $C_2$ bzw. $C_2$') galvanisch nicht verbundene Kompensationsspule koaxial zu den beiden Spulensystemen ($C_1$, $C_2$ bzw. $C_2$') angeordnet ist und einen zusätzlichen im Betriebszustand supraleitend kurzgeschlossenen Strompfad bildet.

9. Magnetanordnung nach Anspruch 7, **dadurch gekennzeichnet, daß** der supraleitend kurzgeschlossene Abschnitt (A) des radial äußeren Spulensystems ($C_2$) einen mit diesem Abschnitt (A) parallel geschalteten und mit dem weiteren supraleitenden Schalter ($S_2$) in Serie geschalteten Strombegrenzer (CL) aufweist.

10. Magnetanordnung nach einem der vorhergehenden Ansprüche, **dadurch gekennzeichnet, daß** die Heizeinrichtungen mindestens zweier supraleitender Schalter ($S_1$, $S_2$) elektrisch in Serie geschaltet sind.

11. Magnetanordnung nach Anspruch 7 oder 9, **dadurch gekennzeichnet, daß** der supraleitende Schalter ($S_2$) des supraleitend kurzgeschlossenen Abschnitts (A; A') eine Heizeinrichtung aufweist, die mit der Heizeinrichtung des supraleitenden Schalters einer Shimeinrichtung elektrisch in Serie geschaltet ist.

12. Magnetanordnung nach Anspruch 10 oder 11, **dadurch gekennzeichnet, daß** die Heizeinrichtung mindestens eines supraleitenden Schalters ($S_1$, $S_2$) separat heizbar ist.

13. Magnetanordnung nach einem der vorhergehenden Ansprüche, **dadurch gekennzeichnet, daß** der supraleitend kurzgeschlossene Abschnitt (A; A') geometrisch so gestaltet und dimensioniert ist, daß die Homogenität des von der Magnetanordnung erzeugten Magnetfelds im Arbeitsvolumen bei Auftreten einer externen Magnetfeldstörung im wesentlichen erhalten bleibt.

14. Magnetanordnung nach einem der vorhergehenden Ansprüche, **dadurch gekennzeichnet, daß** zur induktiven Entkopplung des durch den supraleitend kurzgeschlossenen Abschnitt (A; A') gebildeten Strompfades von den in Serie geschalteten übrigen Teilen der Magnetanordnung eine unterschiedliche Polarität des radial inneren und des radial äußeren Spulensystems ($C_1$, $C_2$ bzw. $C_2$') ausgenutzt wird.

**Claims**

1. Actively shielded superconducting magnet arrangement for generating a magnetic field in the direction of a z axis in a working volume which is disposed about z=0, having a radially inner coil system and a radially outer coil system which is coaxial thereto ($C_1$, $C_2$ and $C_2$', respectively), wherein the two coil systems carry approximately the same current and have approximately equal, but opposite dipole moments, wherein at least parts of the radially outer coil system ($C_2$ and $C_2$', respectively) are electrically connected in series with the radially inner coil system ($C_1$), and wherein a first superconducting switch ($S_1$) is provided which may cause a superconducting short-circuit of a first current path of the magnet arrangement during operation, **characterized in that** a section (A and A', respectively) of the radially outer coil system ($C_2$ and $C_2$', respectively), which is disposed symmetrically relative to the plane z=0, can be superconductingly short-circuited during operation via an additional superconducting switch ($S_2$), and the additional superconducting current path formed by the superconductingly short-circuited section (A;A') of the radially outer coil system ($C_2$;$C_2$') is inductively decoupled from the series-connected other parts of the magnet arrangement, except for any residual couplings due to production inaccuracies, wherein in the event of a homogeneous external magnetic field disturbance, the superconductingly short-circuited section (A and A', respectively) couples with the magnetic field disturbance such that the z component of the magnetic field disturbance in the working volume of the magnet arrangement is largely compensated for by currents induced in the section.

2. Magnet arrangement according to claim 1, **characterized in that** the magnet arrangement is part of an apparatus for high-resolution magnetic resonance spectroscopy.

3. Magnet arrangement according to claim 2, **characterized in that** the magnetic resonance apparatus comprises a device for field-locking the magnetic field generated in the working volume, which is largely decoupled from the superconductingly short-circuited section (A; A').

4. Magnet arrangement according to claim 2 or 3, **characterized in that** the magnetic resonance apparatus comprises sweep coils which are largely decoupled from the superconductingly short-circuited section (A;A').

5. Magnet arrangement according to any one of the preceding claims, **characterized in that** the superconductingly short-circuited section (A;A') consists of the n radially innermost layers of the outer coil system ($C_2$;$C_2$'), wherein preferably $n \leq 4$.

6. Magnet arrangement according to any one of the claims 1 to 5, **characterized in that** the section which is superconductingly short-circuited during operation is resistively connected in series with the other parts of the radially outer coil system.

7. Magnet arrangement according to any one of the claims 1 to 5, **characterized in that** the section which is superconductingly short-circuited during operation is superconductingly connected in series with the other parts of the radially outer coil system.

8. Magnet arrangement according to any one of the preceding claims, **characterized in that** a compensation coil which is not galvanically connected to the two coaxial coil systems ($C_1$, $C_2$ and $C_2$', respectively) is arranged coaxially relative to the two coil systems ($C_1$, $C_2$ and $C_2$', respectively) and forms an additional current path which is superconductingly short-circuited during operation.

9. Magnet arrangement according to claim 7, **characterized in that** the superconductingly short-circuited section (A) of the radially outer coil system ($C_2$) comprises a current limiter (CL) which is connected in parallel with said section (A) and is connected in series with the further superconducting switch ($S_2$).

10. Magnet arrangement according to any one of the preceding claims, **characterized in that** the heating means of at least two superconducting switches ($S_1$, $S_2$) are electrically connected in series.

11. Magnet arrangement according to claim 7 or 9, **characterized in that** the superconducting switch ($S_2$) of the superconductingly short-circuited section (A; A') comprises a heating means which is electrically connected in series with the heating means of the superconducting switch of a shim means.

**12.** Magnet arrangement according to claim 10 or 11, **characterized in that** the heating means of at least one superconducting switch ($S_1,S_2$) can be separately heated.

**13.** Magnet arrangement according to any one of the preceding claims, **characterized in that** the superconductingly short-circuited section (A;A') is geometrically shaped and dimensioned such that the homogeneity of the magnetic field generated by the magnet arrangement in the working volume is substantially maintained when an external magnetic field disturbance occurs.

**14.** Magnet arrangement according to any one of the preceding claims, **characterized in that** different polarities of the radially inner and the radially outer coil systems ($C_1,C_2$ and $C_2$', respectively) are utilized for inductive decoupling of the current path, formed by the superconductingly short-circuited section (A;A'), from the other parts of the magnet arrangement which are connected in series.

**Revendications**

**1.** Dispositif magnétique supraconducteur à blindage actif servant à générer un champ magnétique en direction d'un axe z dans un volume de travail situé autour de z = 0 avec un système de bobines radialement intérieur et un système de bobines radialement extérieur ($C_1$, $C_2$ ou $C_2$') coaxial au premier, les deux systèmes de bobines portant approximativement le même courant et présentant des moments dipolaires approximativement opposés et égaux, dans lequel au moins des parties du système de bobines radialement extérieur ($C_2$ ou $C_2$') sont couplées électriquement en série avec le système de bobines radialement intérieur ($C_1$) et dans lequel il est prévu un premier commutateur supraconducteur ($S_1$) au moyen duquel il est possible de provoquer en fonctionnement un court-circuit supraconducteur d'un premier trajet de courant du dispositif magnétique,
**caractérisé par le fait**
**qu'**un autre commutateur supraconducteur ($S_2$) permet de court-circuiter en fonctionnement de manière supraconductrice une section (A ou A') du système de bobines radialement extérieur ($C_2$ ou $C_2$') disposée symétriquement par rapport au plan z = 0 et que le trajet de courant supplémentaire formé par la section (A ; A') du système de bobines radialement extérieur ($C_2$ ; $C_2$') court-circuitée de manière supraconductrice est découplé inductivement des parties restantes couplées en série du dispositif magnétique, à l'exception d'un éventuel couplage résiduel dû aux imprécisions de production, sachant qu'en cas de survenue d'une perturbation externe homogène du champ magnétique, la section (A ou A') court-circuitée de manière supraconductrice se couple avec la perturbation du champ magnétique de telle manière que la composante z de la perturbation du champ magnétique dans le volume de travail du dispositif magnétique soit en grande partie compensée par des courants induits dans la section.

**2.** Dispositif magnétique selon la revendication 1, **caractérisé par le fait que** le dispositif magnétique fait partie d'un appareil pour la spectroscopie par résonance magnétique à haute résolution.

**3.** Dispositif magnétique selon la revendication 2, **caractérisé par le fait que** l'appareil de résonance magnétique présente un dispositif de stabilisation du champ magnétique généré dans le volume de travail, lequel est en grande partie découplé de la section (A ; A') court-circuitée de manière supraconductrice.

**4.** Dispositif magnétique selon la revendication 2 ou 3, **caractérisé par le fait que** l'appareil de résonance magnétique présente des bobines de balayage, lesquelles sont en grande partie découplées de la section (A ; A') court-circuitée de manière supraconductrice.

**5.** Dispositif magnétique selon l'une des revendications précédentes, **caractérisé par le fait que** la section (A ; A') court-circuitée de manière supraconductrice est constituée des n couches les plus internes radialement du système de bobines radialement extérieur ($C_2$ ; $C_2$'), n étant de préférence $\leq 4$.

**6.** Dispositif magnétique selon l'une des revendications 1 à 5, **caractérisé par le fait que** la section court-circuitée de manière supraconductrice en fonctionnement est couplée en série de manière résistive avec les autres parties du système de bobines radialement extérieur.

**7.** Dispositif magnétique selon l'une des revendications 1 à 5, **caractérisé par le fait que** la section court-circuitée de manière supraconductrice en fonctionnement est couplée en série de manière supraconductrice avec les autres parties du système de bobines radialement extérieur.

**8.** Dispositif magnétique selon l'une des revendications précédentes, **caractérisé par le fait qu'**une bobine de compensation non reliée galvaniquement aux deux systèmes de bobines coaxiaux ($C_1$, $C_2$ ou $C_2$') est disposée coaxialement aux deux systèmes de bobines ($C_1$, $C_2$ ou $C_2$') et forme un trajet de courant supplémentaire, court-circuité de manière supraconductrice en fonctionnement.

**9.** Dispositif magnétique selon la revendication 7, **ca-**

**ractérisé par le fait que** la section (A) court-circuitée de manière supraconductrice du système de bobines radialement extérieur ($C_2$) présente un limiteur de courant (CL) couplé en parallèle avec cette section (A) et couplé en série avec l'autre commutateur supraconducteur ($S_2$).

**10.** Dispositif magnétique selon l'une des revendications précédentes, **caractérisé par le fait que** les dispositifs de chauffage d'au moins deux commutateurs supraconducteurs ($S_1$, $S_2$). sont connectés électriquement en série.

**11.** Dispositif magnétique selon la revendication 7 ou 9, **caractérisé par le fait que** le commutateur supraconducteur ($S_2$) de la section (A ; A') court-circuitée de manière supraconductrice présente un dispositif de chauffage qui est couplé électriquement en série avec le dispositif de chauffage du commutateur supraconducteur d'un dispositif de shim.

**12.** Dispositif magnétique selon la revendication 10 ou 11, **caractérisé par le fait que** le dispositif de chauffage d'au moins un commutateur supraconducteur ($S_1$, $S_2$) est chauffable séparément.

**13.** Dispositif magnétique selon l'une des revendications précédentes, **caractérisé par le fait que** la section (A ; A') court-circuitée de manière supraconductrice est conçue géométriquement et dimensionnée de telle manière que l'homogénéité du champ magnétique généré par le dispositif magnétique dans le volume de travail soit essentiellement maintenue en cas de survenue d'une perturbation externe du champ magnétique.

**14.** Dispositif magnétique selon l'une des revendications précédentes, **caractérisé par le fait que** pour le découplage inductif du trajet de courant formé par la section (A ; A') court-circuitée de manière supraconductrice des autres parties couplées en série du dispositif magnétique, on utilise une polarité différente du système de bobines radialement intérieur et du système de bobines radialement extérieur ($C_1$, $C_2$ ou $C_2$').

Fig. 1

Fig. 3

Fig. 2

EP 1 065 512 B1